# EUROPEAN PATENT SPECIFICATION

(11) **EP 0 405 886 B1**
(45) Date of publication and mention of the grant of the patent: **27.11.1996**
(21) Application number: 90306927.6
(22) Date of filing: 25.06.1990
(51) Int. Cl.: H01L 21/311, H01L 21/306, C09K 13/08

(54) **Surface treatment agent for fine surface treatment**
Oberflächenbehandlungsmittel für Präzisionsoberflächenbehandlung
Agent de traitement de surface pour traitement de surface de précision

(30) Priority: 26.06.1989 JP 163230/89; 21.09.1989 JP 246860/89
(43) Date of publication of application: 02.01.1991
(73) Proprietor: HASHIMOTO CHEMICAL INDUSTRIES CO., LTD., Sakai-shi Osaka (JP)
(72) Inventor: Ohmi, Tadahiro, Sendai-shi, Miyagi-ken (JP); Miki, Masahiro, Osaka (JP); Kikuyama, Hirohisa, Nara-shi, Nara-ken (JP)
(74) Representative: Low, Peter John

(56) References cited:
- EP-A- 0 133 584
- EP-A- 0 159 579
- DE-A- 1 621 662
- FR-A- 2 393 840
- US-A- 3 650 960
- R.C.A. TECHNICAL NOTES, no. 1375, May 1986, pages 1-3, Princeton, New Jersey, US; W. KERN: "Wet etching of BPSG/silicon dioxide films"
- PATENT ABSTRACTS OF JAPAN, vol. 13, no. 110 (E-728)[3458], 16th March 1989; & JP-A-63 283 028 (HASHIMOTO KASEI KOGYO K.K.) 18-11-1988
- IBM TECHNICAL DISCLOSURE BULLETIN, vol. 19, no. 4, September 1976, page 1158, New York, US; M.W. MacINTYRE et al.: "Formulation for a family of silicon dioxide etchants"

## Description

### BACKGROUND OF THE INVENTION

### 1. Field of the Invention:

The present invention relates to composition of a surface treatment agent for fine surface treatment and, more particularly, to a surface treatment agent for use in fine surface treatment which is very effective when employing the same to carry out wet etching for fine treatment of silicon oxide film in the manufacturing process of semiconductor devices, as well as to carry out cleaning of fine-treated semiconductor devices.

### 2. Description of Prior Arts:

Recently, there has been an increasing demand for cleanness, precision and high technology in the steps of cleaning, etching and patterning of wafer surfaces and fine treatment surfaces in wet process of semiconductor integrated circuits under the progress of high integration. So-called buffered hydrogen fluoride such as hydrofluoric acid, mixed solution of hydrogen fluoride and ammonium fluoride has been used for cleaning, etching and patterning as a surface treatment agent for fine surface treatment, and to meet the requirement for submicron ultra high integration, higher performance and function of the buffered hydrogen fluoride has been increasingly demanded.

Buffered hydrogen fluoride is usually prepared by mixing 40% ammonium fluoride and 50% fluoric acid in various mixing ratios, and is applied to the step of etching while controlling etching speed of silicon oxide film from 90 Å/min to 1200 Å/min (10A = 1 nm) in the range of 100 : 1 to 6 : 1, for example. In this case, chemical composition of the buffered hydrogen fluoride is about 35 to 40% ammonium fluoride and about 0.5 to 7% hydrogen fluoride. It is generally considered that ammonium fluoride is necessary for adjustment of etching speed and buffer of chemical action on photoresist.

Several methods for improving wettability of such buffered hydrogen fluoride with respect to surface material of wafer have been recently proposed. For example, U.S. Patent No. 3,650,960 and Japanese Laid-Open Patent Publication (unexamined) No. 63-283028 proposed improvement in uniformity and adehesion of particles in fine etching process by providing wettability by mixing aliphatic carboxylic acid, salt of aliphatic carboxylic acid, aliphatic amine and aliphatic alcohol. In this buffered hydrogen fluoride of such chemical composition, however, a problem exists in that crystallization may take place during the storage in winter season due to high concentration of ammonium fluoride. Thus, to overcome such a problem, the foregoing U.S. Patent No. 3,650,960 and Japanese Laid-Open Patent Publication (unexamined) No. 63-283028 propose also the employment of composition having reduced concentration of ammonium fluoride.

When looking into etching function of buffered hydrogen fluoride acid in detail from the viewpoint of ion chemical reaction mechanism, it is found that the chemical composition employed hitherto is not appropriate from stoichiometric point of view and, moreover, that there is an essential defect of impeding the progress of normal etching reaction therein. Problems in terms of prior chemical composition can be summarized as follows:
(1) To produce HF₂ ⁻ ion which is required for etching of SiO₂ film, HF needs equimolar NH₄F, and concentration of NH₄F exceeding the same makes no contribution to etching reaction.
   Accordingly, increase in mixing ratio of 40% ammonium fluoride to 50% hydrogen fluoride to achieve low etching ratio will bring about increse in unnecessarily excessive concentration of NH₄F.
(2) As a result of measuring solubility of ammonium hexafluoro silicate (NH₄)⁻ ₂SiF₆ which is produced by reaction between SiO₂ film and HF₂⁻ ion and soluble in buffered hydrogen fluoride solution with respect to various buffered hydrogen fluoride, it was recognized that solubility of this product reduced significantly due to increase in concentration of NH₄F.
   Accordingly, it may be said that unnecessarily excessive concentration of NH₄F brings about considerable problem in the aspects of time linearity in fine pattern etching reaction and uniformity in patterning.
(3) Wettability of buffered hydrogen fluoride can be improved by mixing aliphatic hydrocarbon surfactant. There is, however, a limited narrow optimum range in the relation between concentration of surfactant and function thereof. It is an important factor to control the concentration.
   When the concentration of NH₄F is higher, the mentioned optimum range is narrower.

It has been also expected that cleaning function of diluted hydrogen fluoride, when applied to wafer surface or other surface to be finely treated as a cleaner, is considerably improved by giving wettability to the diluted hydrogen fluoride. At present, Japanese Laid-Open Patent Publication No. 63-283028 suggests suitable surfactants but differs from the present invention due to the variation in concentration of the ammonium fluoride.

Cleaning using diluted hydrofluoric acid is one of the important processes, and in which smoothness of cleaned surface is a very important factor in submicron devices. There remains some dry spot in silicon wafer surface etched with buffered hydrogen fluoride. It is said that the dry spot can be normalized by mixing a suitable surfactant, as is proposed by Japanese Laid-Open Patent Publication No. 63-283028. However, as a result of analyzing a silicon wafer cleaned with diluted hydrogen fluoride, it was found that smoothness of the cleaned surface was damaged. This kind of damage results in grave problem, for example, in the formation of shallow junction. Accordingly, it seems essential to develop means for achieving smoothness on the surface by providing wettability even in the cleaning step with diluted hydrogen fluoride.

### SUMMARY OF THE INVENTION

An object of the present invention is, therefore, to establish chemical composition of buffered hydrogen fluoride to be used as etching agent so that essential mechanism of chemical reaction of etching take place normally, that chemical protection of photoresist is secured, and that performance range for giving wettability is enlarged.

Another object of the invention is to improve performance of diluted hydrogen fluoride to be used as cleaning agent by giving wettability thereto so that smoothness on cleaned surface is achieved.

As a result of researches and developments, it has been found by the inventors that uniformity and completeness of submicron pattern etching can be achieved by reducing NH₄F concentration of buffered hydrogen fluoride to less than 15% and preparing HF concentration to be in the range of less than 8% thus maintaining etching speed of SiO₂ film up to 1500 A/min and resist protectability. It has been also found by the inventors that, in the mentioned NH₄F concentration, the mixing range of hydrocarbon surfactant is enlarged thereby increasing available amount of carbon, and that performance range of the surfactant is also enlarged thereby cleanness on the etching surface being improved. It has been further recognized by the inventors that hydrocarbon surfactant exhibits wettability by mixing a certain amount of ammonium fluoride with diluted hydrogen fluoride, and that smoothness on cleaned surface is achieved by utilizing such wettability, thus coming to make this invention.

The surface treatment agent for fine surface treatment in accordance with the present invention comprises any of the followings:-
(1) A surface treatment agent for fine surface treatment comprising an aqueous solution containing 0.01 to 8% by weight of hydrogen fluoride and 0.01 to 15% by weight (excluding 15% by weight) of ammonium fluoride, said aqueous solution further containing one surfactant selected from the group comprising aliphatic carboxylic acid, salt thereof, aliphatic amine, and aliphatic alcohol.
(2) A surface treatment agent as set forth in the mentioned (1), said surfactant being an aliphatic amine, said aqueous solution containing at least one additional surfactant selected from the group consisting of aliphatic carboxylic acid, salt thereof, and aliphatic alcohol.
(3) A surface treatment agent as set forth in any of the mentioned (1) or (2), said surface treatment agent being an etching agent for silicon oxide film.
(4) A surface treatment agent as set forth in any of the mentioned (1) or (2), said surface treatment agent being a cleaning agent for silicon surface and semiconductor device surface.

In the low concentration area of ammonium fluoride according to the invention, performance of surfactant is exhibited more sufficiently. On the other hand, in the high concentration area of ammonium fluoride, performance of surfactant is exhibited only when carbon number of surfactant is not more than 12. As a result of tests on effective area by mixing surfactant with buffered hydrogen fluoride of low ammonium fluoride concentration, it was recognized that surfactant of larger carbon number also exhibited its performance if concentration of ammonium fluoride was in the range of less than 15%. In other words, wettability was desirably controlled by preparing an ammonium fluoride whose concentration was less than 15%.

Aliphatic amine improves wettability be lowering contact angle of treatment agent. Foaming force of the aliphatic amine, however, is large and therefore gives undesirable influence to manufacturing process of semiconductor if using it as it is. To restrict such foaming force, it is useful to add aliphatic carboxylic acid or aliphatic alcohol both having defoaming capability, thus a treatment agent of small foaming force and satisfiable performance being prepared. Though both aliphatic carboxylic acid and aliphatic alcohol exhibited defoaming capability alone in the high ammonium fluoride concentration area, it was recognized that they brought not only defoaming capability but also improvement in wettability in low ammonium fluoride concentration area of less than 15%.

Aliphatic amine being one of the surfactants used in the invention are a compound expressed by the chemical formula CₘH₂ₘ₊₁NH₂ (where: n indicates an interger not larger than 25) and secondary or tertiary amine as shown below, for example:
C₇H₁₅NH₂, C₈H₁₇NH₂, C₉H₁₉NH₂, C₁₀H₂₁NH₂, C₁₂H₂₅NH₂ , C₁₄H₂₉NH₂, C₁₆H₃₃NH₂, C₁₈H₃₇NH₂, C₂₀H₄₁NH₂, 2-(C₂H₅)-C₇H₁₄NH₂, (C₅ H₁₁)₂NH, (C₁₀H₂₁)₂NH, (CH₃)₂(C₁₀H₂₁)N, (C₈H₁₇)₃N

Aliphatic carboxylic acid is a compound expressed by the chemical formula CₙH_{2n + 1}COOH (where: n indicates an interger not larger than 25) as shown below, for example:
C₅H₁₁COOH, C₆H₁₃COOH, C₇H₁₅COOH, C₈H₁₇COOH, C₉H₁₉COOH, C₁₀H₂₁COOH, C₁₂H₂₅COOH, C₁₄H₂₉COOH, C₁₆H₃₃COOH, C₁₈H₃₇COOH,

Aliphatic carboxylic acid salt is a compound expressed by the chemical formula CₙH_{2n + 1} COONH₃R (where: R indicates hydrogen atom or alkyl group and n indicates an interger not larger than 25) as shown below, for example:
C₅H₁₁COONH₃, C₇H₁₅COONH₃(H₁₅C₇), C₈H₁₇COONH₃(H₁₇C₃), C₇H₁₅COONH₃(H₁₅C₇), C₇H₁₅COONH₄, C₈H₁₇COONH₄, C₁₄H₂₉NH₃OCC₁₄H₂₅

Aliphatic alcohol is a compound expressed by the chemical formula CₙH₂ₙ₊₁OH (where: n indicates an interger not larger than 25) as shown below, for example:
C₆H₁₃OH, C₇H₁₅OH, C₈H₁₇OH, C₈H₁₉OH, C₁₀H₂₁OH, C₁₂H₂₅OH, C₁₇H₃₅OH, C₁₈H₃₇OH, C₂₀H₄₁OH

The mentioned surfactants are used simply or by mixing more than two in the form of solid or liquid. Amount of addition is in the range of 10 to 10000 ppm with respect to all composition, preferably in the range of 50 to 1000 ppm. If amount of addition is less than 10 ppm, effect of addition is hardly exhibited. On the other hand, if it is more than 10000 ppm, no effect corresponding to the exceeding amount is achieved.

It was acknowledged that sufficient buffering was achieved by the treatment agent according to the invention.

Described hereinafter are results of experiments carried out by the inventors and served as fundament of the invention.

### 1. Etching rate of SiO₂ film and composition of BHF:

To produce SiF₆⁻² by dissolving SiO₂, presence of ion is essential. Reaction of dissolving SiO₂ using HF solution proceeds through the following dissociation expressions (1), (2) and (3), and dissolving speed depends exclusively upon equilibrium constant of the dissociation expressions (1) and (2):

HF + H₂O = H₃O+ + F⁻ (1)

HF + H₃O⁺ + F⁻ = H₃O⁺ + HF₂ ⁻ (2)

SiO₂ + 4HF₂⁻ = SiF₆²⁻ + 2F⁻ + 2H₂O (3)

Reaction of dissolving SiO using HF solution proceeds through the following dissociation expression (4), and dissolving rate depends exclusively upon equilibrium constant of the dissociation expression (4):

NH₄HF₂ = NH₄⁺ + HF₂⁻ (4)

According to stoichiometric ratio, 8 moles of HF and 4 moles of NH₄HF₂ are equivalent with respect to 1 mole of SiO₂. Because degree of dissociation of expressions (1) and (2) is smaller than that of expression (4), it is obvious from etching rates of liquid compositions ① and ② shown in the following Table 1 that HF requires very high concentration as compared with NH₄HF₂.

**TABLE 1**

| BHF composition and SiO₂ film etching rate | | | | | | | | | |
|---|---|---|---|---|---|---|---|---|---|
| Liquid Comp. | NH₄HF₂ | : | HF | : | NH₄F | (NH₄F | : | HF ) | Etching rate |
| | Mol/ℓ | | Mol/ℓ | | Mol/ℓ | % | | % | Å/min (25°C) |
| ① | - | | 5 | | - | ( 0.0 | : | 10.0) | 800 |
| ② | 2 | | - | | - | ( 7.4 | : | 4.0) | 800 |
| ③ | 2 | | - | | 8 | (37.0 | : | 4.0) | 650 |

In this way, it is a matter of course that using so-called buffered hydrogen fluoride mixed with NH₄F is more effective than using HF alone. However, it has never been recognized that addition of NH₄F to HF exceeding the equivalent makes no contribution to dissolving reaction. It is to be noted that etching rate is lowered in the composition ③ excessively mixed with NH₄F as compared with the composition ② because of dissociative retardation in the expression (4) due to increase in NH₄F concentration, in spite of the same HF concentration.

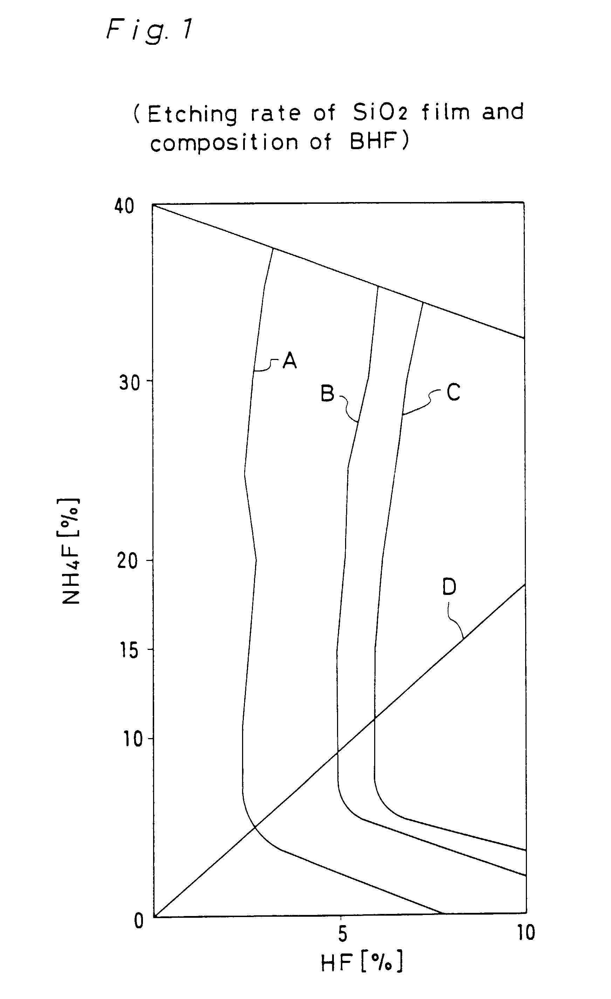

Figure 1 shows such a relationship as mentioned above between the etching rate of SiO₂ film and BHF composition, and in which A, B, C and D respectively indicate followings:
A: 500 Å/min
B: 1000 Å/min
C: 1200 Å/min
D: NH₄HF₂

Table 2 shows etching rates obtained by fixing HF concentration to 4% while changing NH₄F concentration.

**TABLE 2**

| NH₄F concetration (%) | HF concetration (%) | Etching rate |
|---|---|---|
| 35 | 4 | 670 |
| 30 | 4 | 721 |
| 25 | 4 | 761 |
| 20 | 4 | 741 |
| 15 | 4 | 784 |
| 10 | 4 | 790 |
| 5 | 4 | 722 |
| 3 | 4 | 475 |

In the same manner, etching rates were obtained respectively on 0.5 wt %, 1 wt %. 2 wt %, 6 wt % and 8 wt % HF concentrations. As a result of this, it was found that BHF composition for obtaining usually required etching rate of 90 to 1500 Å/min can be satisfiably achieved when NH₄F concentration is not more than 15%, and therefore it may be said that concentration of 30 to 40% mainly adopted at present in the art is quite unnecessary from the viewpoint of etching rate.

### 2. Solubility of (NH₄)₂SiF₆ and concentration of NH₄F:

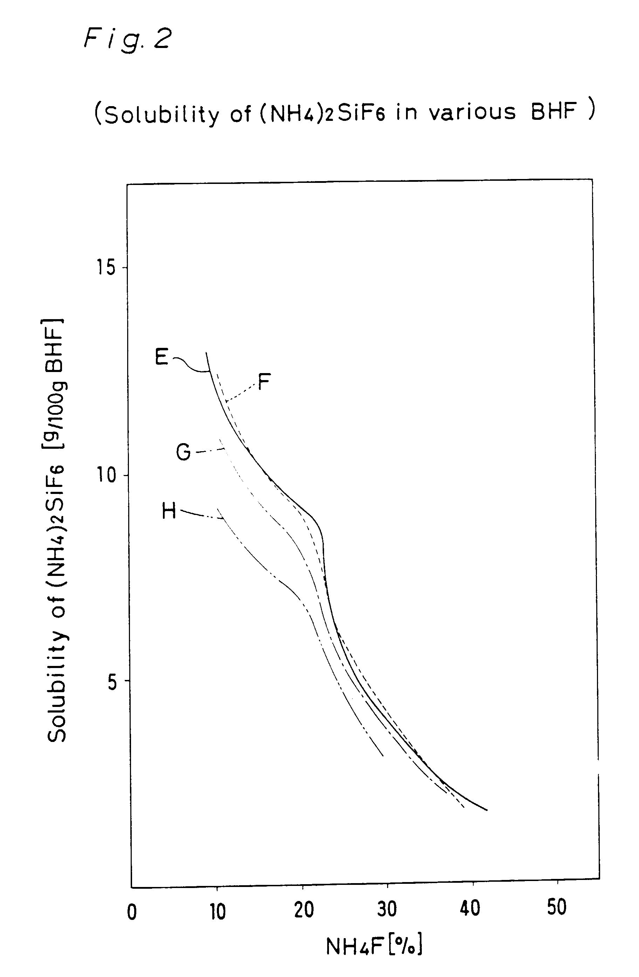

Figure 2 shows results of measurement on solubility of (NH₄)₂SiF₆ in solutions of various BHF composions. It is understood from Figure 2 that solubility of (NH₄)₂SiF₆ reduces significantly in accordance with reduction of NH₄F concentration. In Figure 2 symbols E, F, G and H indicate respectively in order HF = 0%, HF = 0.5%, HF = 2.4% and HF = 6.0%.

### 3. Influence of saturation of (NH₄)₂SiF₆ in pattern etching of SiO₂ film:

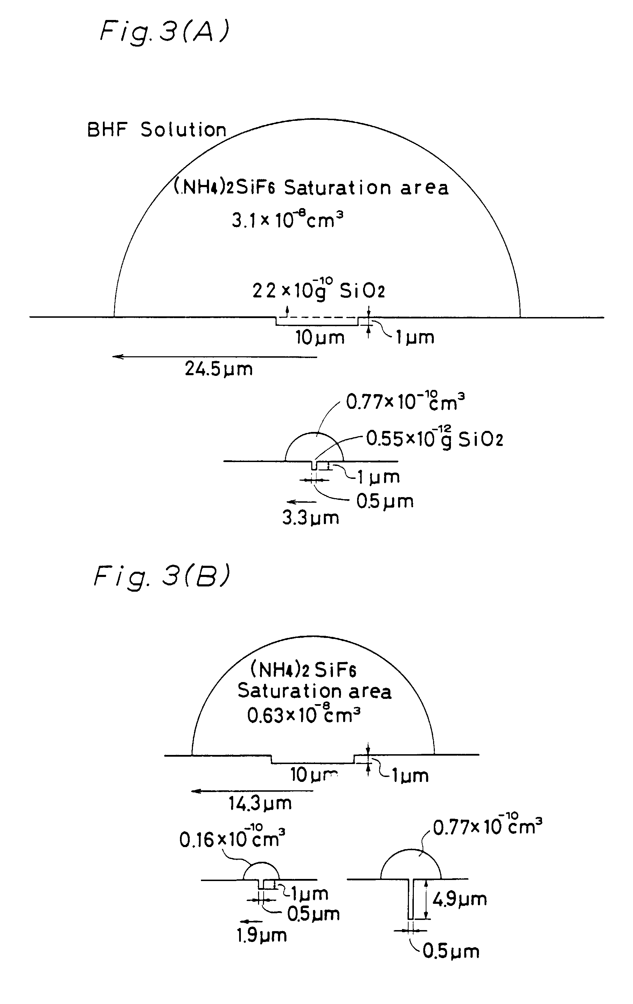

When increasing concentration of (NH₄)₂SiF₆ in BHF by the etching of SiO₂ film thereby reaching saturated concentration, etching operation is stopped by crystallization of (NH₄)₂SiF₆. Simulation of (NH₄)₂SiF₆ saturation range at etching point can be performed by utilizing solubility data of (NH₄)₂SiF₆. Since it was very difficult to idealize variation in "SiF₆²⁻ ion diffusion speed/SiO₂ etching speed" in accordance with conditions such as concentration, temperature and variation in liquid composition due to reaction, in the actual simulation, model was established in such a manner that liquid phase portion, wherein SiF₆²⁻ ion produced by reaction reached saturated concentration of BHF at the initial composition thereof, was semi-spherically expanded from etching point, and necessary calculation was made on such model. Figure 3 shows the simulation. Referring to Figure 3, for carrying out etching with a depth of 1 µm on contact holes whose size is 10 µm and 0.5 µm respectively, if solubility of (NH₄)₂SiF₆ is different in the ratio of 1 : 5, saturation area of (NH₄)₂SiF₆ of BHF solution is also different in a ratio of 1 : 5, and accordingly it is obivous that BHF of higher NH₄F concentration is more influenced by precipitation of saturated (NH₄)₂SiF₆. There are several points to be noted in this respect.

The first point to be noted relates to size of contact hole. Saturation area of (NH₄)₂SiF₆ becomes larger when hole size is larger, i.e., in proportion to a square of hole size. Table 2 shows a relationship between hole size and unevensess in etching. It is understood from the table that degree of incomplete etching is considerably high in 10 µm hole as compared with hole not more than 1 µm, which clearly shows influence by saturation of (NH₄)₂SiF₆.

The second point to be noted relates to aspect ratio of hole. As shown in Figure 3, with respect to the same saturated area, aspect ratio of a hole being able to be etched is in inverse proportion to solubility of (NH₄)₂SiF₆

This influence becomes more significant when hole size is smaller. Thus, as shown in Figure 3, aspect ratio of etching with BHF of high NH₄F concentration is restricted to be small in submicron etching.

As a result of the mentioned simulation and etching data, it was made clear by the inventors how excessive concentration of NH₄F gave undesirable influnce to etching. Figures 3 (A) and (B) show respectively the following compositions:

| | | |
|---|---|---|
| (A) | NH₄F | 38.1 % |
| | HF | 2.4 % |
| | SpGr | 1.114 |
| | Solubility of (NH₄)₂SiF₆ : 1.9/100g BHF(20°C); | |
| (B) | NH₄F | 15.1 % |
| | HF | 2.4 % |
| | SpGr | 1.114 |
| | Solubility of (NH₄)₂SiF₆ : 9.4/100g BHF(20°C). | |

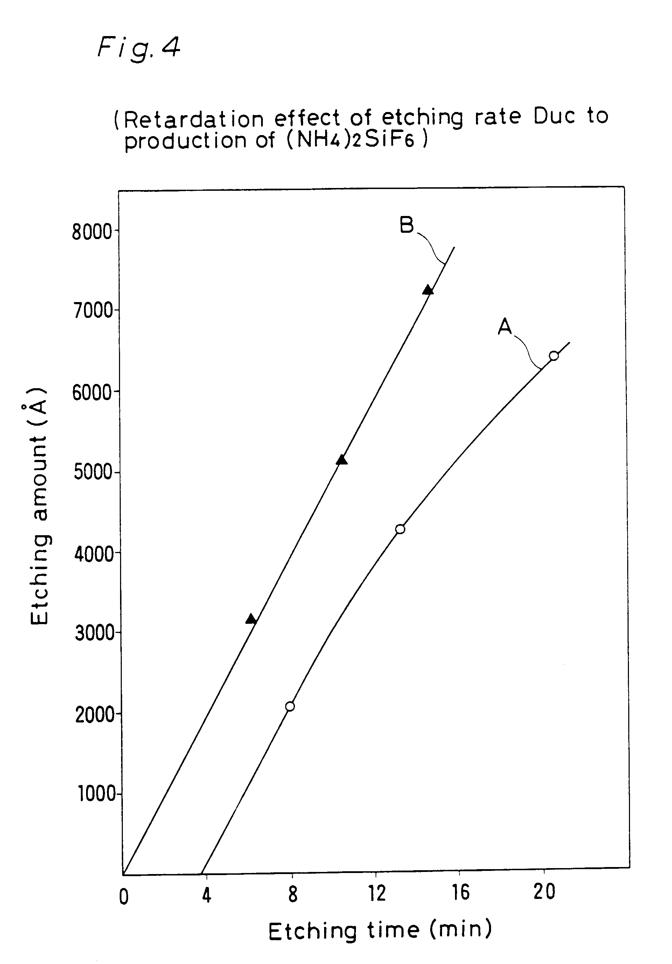

The third point to be noted is influence of saturation of (NH₄)₂SiF₆on durability of etching rate. As shown in Figure 4, since solubility of (NH₄)₂SiF₆ is small in BHF of high NH₄F concentration, slow down in etching rate comes sooner. In this respect, Figure 4 shows an etching amount of square hole of 10 µm in 2.4% of HF measured at 25°C, and in which symbols A and B indicate following respectively:
A : NH₄F is 38.1%
B : NH₄F is 15.0%

It is understood from the data mentioned in 1 to 3 that, in the cleaning and fine pattern etching of silicon oxide film using an etching agent comprising hydrogen fluoride and ammonium fluoride, the conventionally employed ammonium fluoride concentration of 15 to 40%, more popularly 30 to 40%, brings about not only slow down in etching rate but also reduction in solubility of ammonium hexafluoro silicate, which results in grave problems of increase in drawback of uneven etching and undesirable aspect ratio of etching. It is also understood from the mentioned expressions (1) to (4) that suitable concentration of NH₄F necessary for obtaining the etching rate of 800 to 1500 Å/min at 25°C to etch thermal oxide film is not more than 15%, preferably not more than 10%.

### 4. Functional area of surfactant and concentration of NH₄F

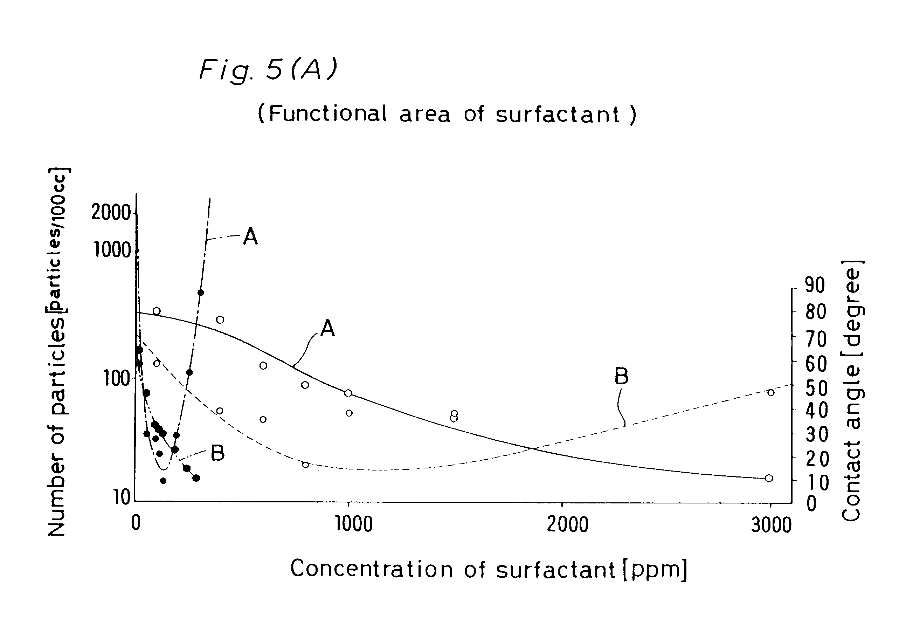

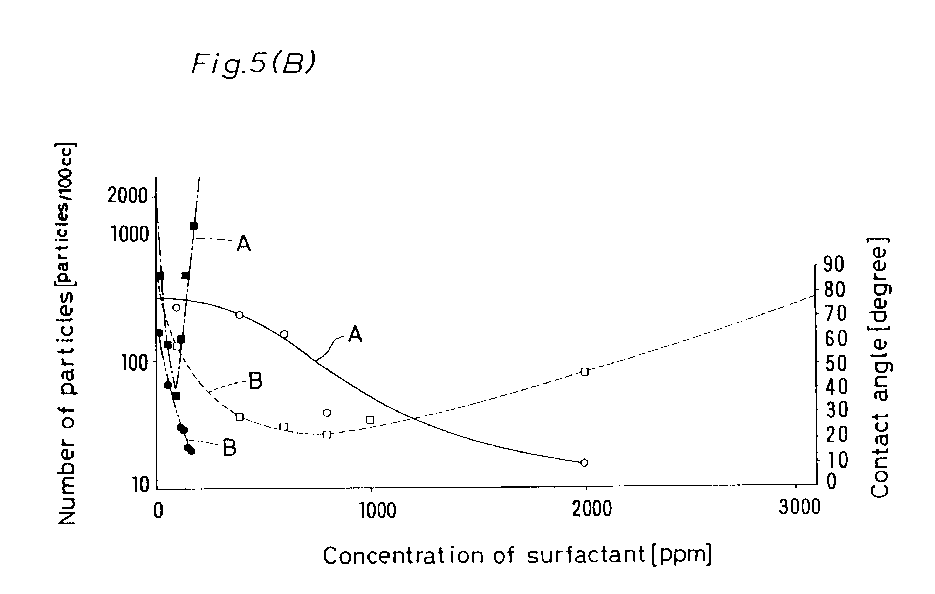

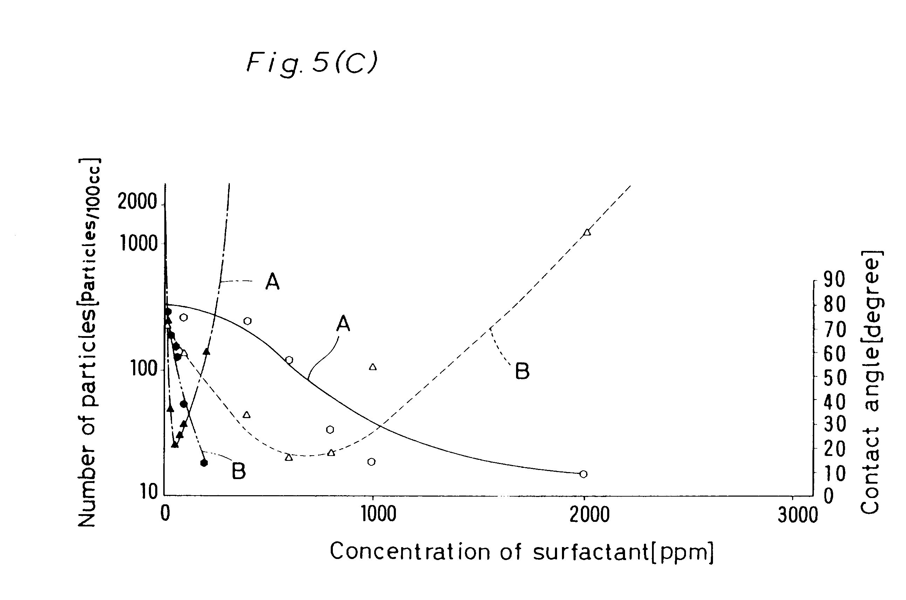

Wettability on the wafer surface can be improved by mixing buffered hydrogen fluoride with hydrocarbon surfactant thereby reducing contanct angle, and further fine particles in buffered hydrogen fluoride can be filtered to be clean in the specific concentration area of surfactant. This specific concentration area of surfactant is herein called area of functional concentration. Figure 5 shows clearly that such area of functional concentration depens upon concentration of NH₄F in buffered hydrogen fluoride. acid.

It is certain that contact angle is lowered according to addition of surfactant, but on and from a certain concentration the contact angel is constant. This concentration point is called "critical micell concentration (CMC)". If concentration of NH₄F is high, the curve coming to CMC point is sharp, and width of area of functional concentration of surfactant having small number of particles is small. If adding surfactant slightly exceeding such width or control range, stain due to micell may be found at the time of etching of silicon oxide film. On the other hand, if concentration of NH₄F is less than 15%, curve coming to CMC point is gentle, and width of are of functional concentration of surfactant having small number of particles is large. At the time of etching silicon oxide film, no generation of stain was found. As a result of this, since the area of functional concentration of surfactant is enlarged in buffered hydrogen fluoride whose NH₄F concentration is less than 15%, it may be said that buffered hydrogen fluoride excellent in wettability and cleanness can be adjusted within sufficiently wide control range. In Figure 5 (A), (B) and (C), marks ○ and ● show followings respectively. In addition, symbols A indicates contact angle and B indicates number of particles.
(A) Mark ○ indicates HF: 5.4% and NH₄F: 15.0%;
   Mark ● indicates HF: 5.4% and NH₄F: 30.0%;
(B) Mark ○ indicates HF: 2.4% and NH₄F: 15.0%;
   Mark ● indicates HF: 2.4% and NH₄F: 38.1%;
(C) Mark ○ indicates HF: 0.5% and NH₄F: 15.0%; and
   Mark ● indicates HF: 0.5% and NH₄F: 39.6%.

### 5. Crystallization temperature

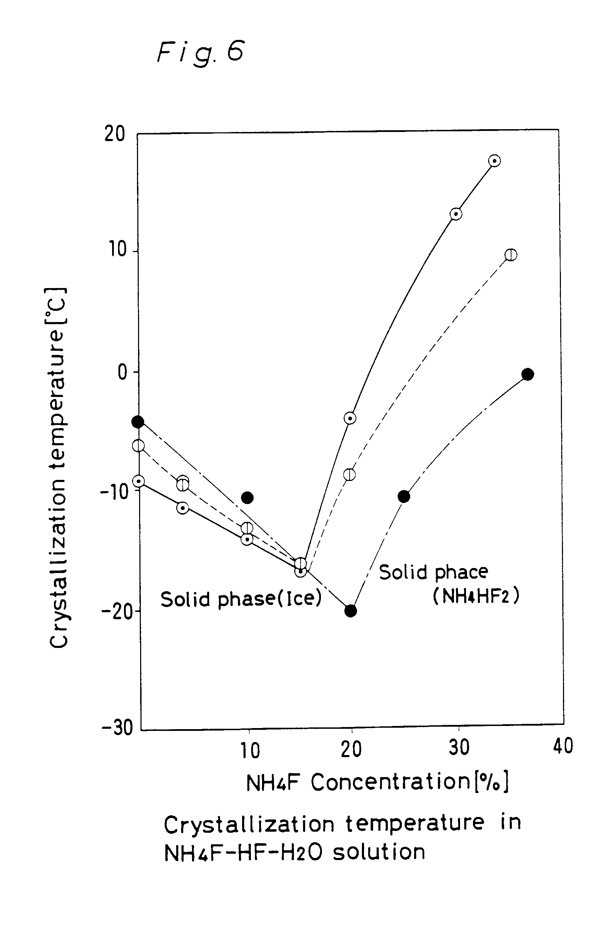

In high NH₄F concentration area, crystallization of NH₄HF₂ may occur in buffered hydrogen fluoride. This crystallization may cause variation in etching speeds i.e., trouble in the process of wet etching. In this respects it was recognized by the inventors that there existed two relative curves in the crystallization according to change in concentration of NH₄F. One is a freezing point depression curve, and another is a crystallization curve. In low NH₄F concentration area, freezing point goes lower according to increase of NH₄F. Solid phase crystallized in this area is ice. The lowest point comes at about 15%, and over this point is transferred to crystallization area and crystallization temperature is increased. Solid phase crystallized in this area is NH₄HF₂. Figure 6 shows a result of such situation. It is understood from Figure 6 that crystallization of NH₄HF₂ can be restricted to a great extent by reducing the NH₄F concentration to less than 15%. Furthermore, even when icing takes place, there is no influence on etching rate because the ice melts easily by increasing temperature. In Figure 6, the marks indicate followings respectively:
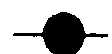 : 4% HF
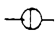 : 6% HF
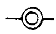 : 8% HF

### 6. Smoothness on the cleaned surface

For cleaning silicon surface or fine treated semi-conductor device surface, a diluted solution of fluoric acid has been generally employed. Such cleaning with hydrogen fluoride, however, has a drawbacks of occurring dry spot on the cleaned surface. In order to prevent generation of such dry spot, addition of surfactant is required. Actually, there has been no suitable surfactant capable of giving wettability and reduction of particles to diluted hydrogen fluorided. In this respect, it was found by the inventors that when adding a little amount of NH F to diluted hydrogen fluoride, then it was possible to exhibit the mentioned wettability and other performances by addition of surfactant. It was, thus, recognized that not only wettability was improved but also cleaned surface was prevented from occurrence of dry spot. Table 14 shows a result of such situation. Formation of shallow junction is easy by making the cleaned surface smooth.

Employment of surfactant is preferable in view of improvement is cleaning, and in particular it is preferable for surfactant to be used together with at least one of aliphatic amine, aliphatic carboxylic acid or aliphatic alcohol.

### 7. Capability of selective etching:

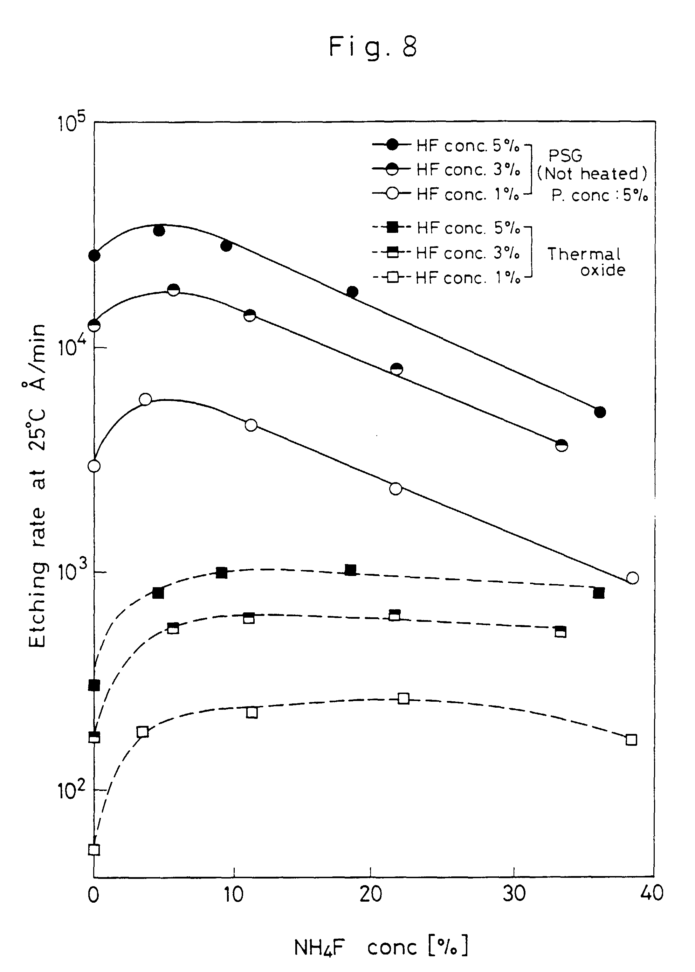

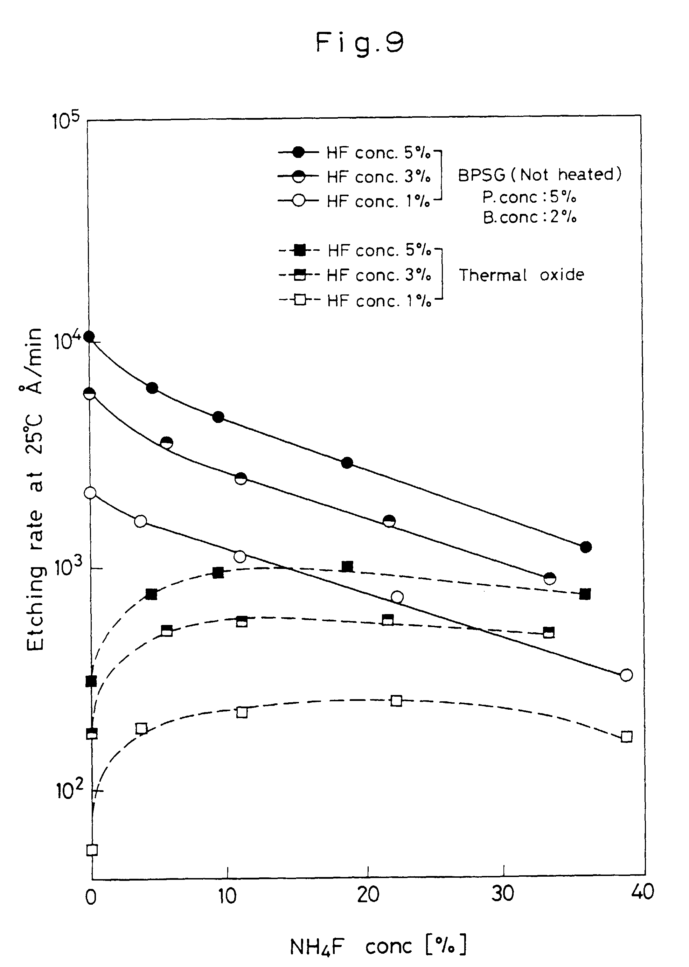

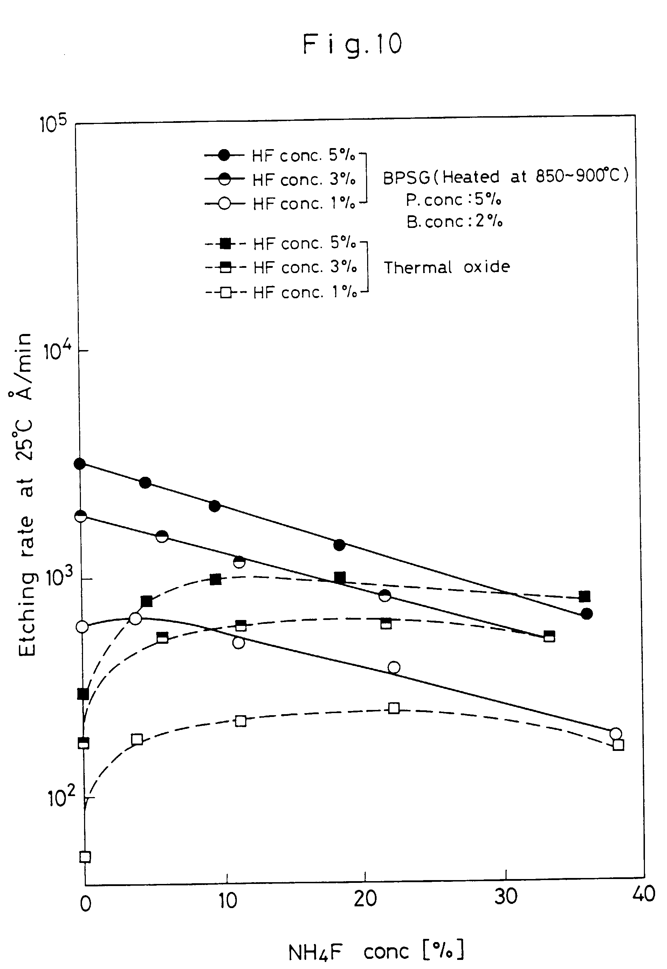

Etching rate for etching PSG film, BPSG film and thermal oxide film can be varied by reducing concentration of ammonium fluoride. Figures 8 to 10 are diagrams each showing a result of etching rate measured on various oxide films.

When using a buffered hydrogen fluoride of 5.0% hydrogen fluoride and 4.6% ammonium fluoride, etching rate of thermal oxide film was 772 Å/min. On the other hand, etching rate of PSG film was 33700 Å/min, that of BPSG film (without heat treatment) was 6370 Å/mim, and that of BPSG film (heat treated) was 2614 Å/min. This means that etching rates of these PSG and BPSG films were respectively 43.7 times, 8.25 times and 3.4 times as high as the etching rate of thermal oxide film. Accordingly, making use of these differences in etching rate, when etching some film wherein thermal oxide film and PSG film are coexistent, for example, the PSG film alone is etched while remaining not etched the thermal oxide film. In this manner, selctive etching is accomplished.

As described so far, it is now achieved by the invention, as a result of reducing concetration of ammonium fluoride, to increase solubility of ammonium hexafluoro silicate thereby eliminating poor performance in pattern etching being and to exhibit etching of high aspect ratio. Since concentration of ammonium fluoride is lower than the conventional buffered hydrogen fluoride, not only hydrocarbon surfactant of larger carbon number can be used but also such performance as wettability, cleanness can be satisfiably presented. Furthermore, range of addition amount is wider than ever, which results in easiness in control. Chemical action on resist is sufficiently easened according to the invention in spite of low concentration of ammonium fluoride. The invention is advantageous not only in cleaning of highly integrated semiconductor device, silicon wafer or fine processed surface, but also in smoothening of surface at the time of forming shallow junction, thus the conventional drawbacks being overcome.

### BRIEF DESCRIPTION OF THE DRAWINGS

Figure 1 is a graphic diagram showing a relationship between etching rate of SiO₂ film and composition of BHF at 25°C;
Figure 2 is a graph showing solubility of (NH₄)₂SiF₆ in various BHF compositions at 25°C;
Figures 3(A) and (B) are diagrams each showing simulation (SiO₂ + BHF → (NH₄)₂SiF₆) of saturation area of (NH₄)₂SiF₆ in BHF solution when etching contact holes;
Figure 4 is a graph showing retardation effect of etching rate due to production of (NH₄)₂SiF₆;
Figures 5(A) and (B) are graphs each showing area of functional concentration of surfactant;
Figure 6 is a graph showing crystallization concentration;

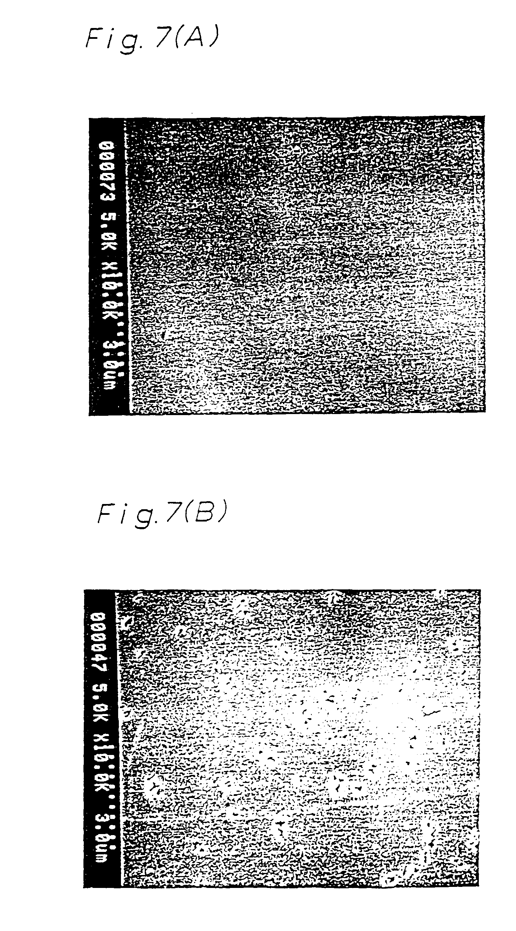

Figure 7(A) and (B) are diagrams each showing a simulation of microphotographs of wafer surface; and
Figures 8 to 10 are diagrams each showing a result of etching rate measured on various oxide films.

### Examples

Described in detail hereinafter are examples of the invention.

### Example 1:

Contact holes each being 10 um in diameter were etched with HF concentrations shown in Table 3 with the use of solutions each having 9.9% NH₄F concentration. Percentage of defective contact holes was measured with an optical microscope. Table 3 shows the result.

**TABLE 3**

| NH₄F Con. (%) | HF Con. (%) | Etching Depth (Å) | Defective hole (%) |
|---|---|---|---|
| 9.9 | 0.5 | 3000 | 0 |
| 9.9 | 0.5 | 5000 | 0 |
| 9.9 | 0.5 | 7000 | 0 |
| 9.9 | 2.4 | 3000 | 0 |
| 9.9 | 2.4 | 5000 | 0 |
| 9.9 | 2.4 | 7000 | 0 |
| 9.9 | 5.4 | 3000 | 0 |
| 9.9 | 5.4 | 5000 | 0 |
| 9.9 | 5.4 | 7000 | 0 |

### Comparative Example 1:

Using solutions each having composition shown in Table 4, the same treatment as the mentioned Example 1 was carried out. Table 4 shows the result.

**TABLE 4**

| Composition of solution | | Etching Depth (Å) | Defective hole (%) |
|---|---|---|---|
| NH F Con. (%) | HF Con. (%) | | |
| 39.6 | 0.5 | 3000 | 99.6 |
| 39.6 | 0.5 | 5000 | 100 |
| 39.6 | 0.5 | 7000 | 100 |
| 39.6 | 2.4 | 3000 | 99.5 |
| 39.6 | 2.4 | 5000 | 100 |
| 39.6 | 2.4 | 7000 | 99.3 |
| 39.6 | 5.4 | 3000 | 96.9 |
| 39.6 | 5.4 | 5000 | 97.4 |
| 39.6 | 5.4 | 7000 | 96.5 |

### Example 2:

Various contact holes were etched with the use of solutions each having concentration shown in Table 5. Percentage of defective contact holes was measured with an optical microscope. Table 5 shows the result.

**TABLE 5**

| Composition of solution | | Contact hole size (µm) | Defective hole (%) |
|---|---|---|---|
| NH₄F Con. (%) | HF Con. (%) | | |
| 9.9 | 0.5 | 10.0 | 0 |
| 9.9 | 0.5 | 1.0 | 0 |
| 9.9 | 0.5 | 0.9 | 0 |
| 9.9 | 0.5 | 0.8 | 0 |
| 9.9 | 0.5 | 0.9 | 0 |
| 9.9 | 2.4 | 10.0 | 0 |
| 9.9 | 2.4 | 1.0 | 0 |
| 9.9 | 2.4 | 0.9 | 0 |
| 9.9 | 2.4 | 0.8 | 0 |
| 9.9 | 2.4 | 0.7 | 0 |
| 9.9 | 5.4 | 10.0 | 0 |
| 9.9 | 5.4 | 1.0 | 0 |
| 9.9 | 5.4 | 0.9 | 0 |
| 9.9 | 5.4 | 0.8 | 0 |
| 9.9 | 5.4 | 0.7 | 0 |

### Comparative Example 2:

Various contact holes were etched with the use of solutions each having concentration shown in Table 6. Percentage of defective contact holes was measured with an optical microscope. Table 6 shows the result.

**TABLE 6**

| Composition of solution | | Contact hole size (µm) | Defective hole (%) |
|---|---|---|---|
| NH₄F Con. (%) | HF Con. (%) | | |
| 39.6 | 0.5 | 10.0 | 99.6 |
| 39.6 | 0.5 | 1.0 | 91.5 |
| 39.6 | 0.5 | 0.9 | 91.0 |
| 39.6 | 0.5 | 0.8 | 86.6 |
| 39.6 | 0.5 | 0.9 | 68.9 |
| 38.1 | 2.4 | 10.0 | 99.5 |
| 38.1 | 2.4 | 1.0 | 74.2 |
| 38.1 | 2.4 | 0.9 | 61.0 |
| 38.1 | 2.4 | 0.8 | 43.8 |
| 38.1 | 2.4 | 0.7 | 38.0 |
| 30.0 | 5.4 | 10.0 | 96.9 |
| 30.0 | 5.4 | 1.0 | 71.1 |
| 30.0 | 5.4 | 0.9 | 59.8 |
| 30.0 | 5.4 | 0.8 | 45.3 |
| 30.0 | 5.4 | 0.7 | 40.1 |

### Example 3:

After etching contact holes of 0.7 µm for a certain time with the use of a solution composed of 0.5% HF concentration and 9.9% NH₄F concentration, etched depth section was measured by electronic microscope to obtain aspect ratio (opening width/depth). Table 7 shows the result.

**TABLE 7**

| Composition of solution | | Etching time (min) | Aspect ratio |
|---|---|---|---|
| NH₄F Con. (%) | HF Con. (%) | | |
| 9.9 | 0.5 | 30 | 0.10 |
| 9.9 | 0.5 | 50 | 0.30 |
| 9.9 | 0.5 | 70 | 0.40 |

### Comparative Example 3:

Etching was carried out in the same manner and conditions as the mentioned Example 3 except that concentration of NH₄F was set to 39.6%. Table 8 shows the result.

**TABLE 8**

| Composition of solution | | Etching time (min) | Aspect ratio |
|---|---|---|---|
| NH₄F Con. (%) | HF Con. (%) | | |
| 39.6 | 0.5 | 30 | 0.10 |
| 39.6 | 0.5 | 50 | 0.30 |
| 39.6 | 0.5 | 70 | 0.40 |

### Example 4

After etching contact holes of 10 µm with the use of a solution composed of 2.4% HF concentration and 9.9% NH₄F concentration, etched depth was measured by step gage. Table 9 shows the result.

**TABLE 9**

| Composition of solution | | Etching time (min) | Etched amount (Å) |
|---|---|---|---|
| NH₄F Con. (%) | HF Con. (%) | | |
| 9.9 | 2.4 | 6 | 3100 |
| 9.9 | 2.4 | 10 | 5100 |
| 9.9 | 2.4 | 14 | 7200 |

Figure 4 also shows the result, and from which it is understood that the etching speed is shown in the form of a straight line passing through the origin, which means that etching speed is constant.

### Comparative Example 4:

Etching was carried out in the same manner and conditions as the mentioned Example 4 except that concentration of NH₄F was set to 38.1%. Table 10 shows the result.

**TABLE 10**

| Composition of solution | | Etching time (min) | Etched amount (Å) |
|---|---|---|---|
| NH₄F Con. (%) | HF Con. (%) | | |
| 38.1 | 2.4 | 8 | 2050 |
| 38.1 | 2.4 | 12.5 | 4250 |
| 38.1 | 2.4 | 18.0 | 6300 |

As shown in Figure 4, etching speed curve does not pass through the origin. That is, start of etching is delayed and etching speed goes slown down.

### Example 5:

Contact holes of 10 µm were etched with the use of a solution prepared by adding HF of concentration shown in Table 11 to 5% NH₄F concentration, then the result was measured by optical microscope. Figure 11 shows the result.

**TABLE 11**

| Etched depth (Å) | Defective 10 µm contact hole (%) | | | |
|---|---|---|---|---|
| | NH₄F Con. (%) | HF Con. | | |
| | | 0.5% | 2.4% | 6.0% |
| 3000 | 5.0 | 0 | 0 | 0 |
| 5000 | 5.0 | 0 | 0 | 0 |
| 7000 | 5.0 | 0 | 0 | 0 |

### Example 6:

Contact holes of 10 µm and 1.0 µm were etched with the use of a solution prepared by adding a predetermined amount of surfactants shown in Table 12 to a solution of 9.9% NH₄F concentration and 0.5% HF concentration, then the percentage of defective contact holes was measured by optical microscope. Figure 12 shows the result.

**TABLE 12**

| Surfactant | | Defective contact hole (%) | |
|---|---|---|---|
| Kind | Con. | 10 µm contact hole | 1 µm contact hole |
| C₈H₁₇NH₂ | 500 | 0 | 0 |
| C₈H₁₇COOH | 200 | | |
| C₁₀H₂₁NH₂ | 140 | 0 | 0 |
| C₁₀H₂₁OH | 80 | | |
| C₁₄H₂₉NH₄ | 100 | 0 | 0 |
| C₁₄H₂₉COOH | 60 | | |
| C₁₈H₃₇NH₂ | 80 | 0 | 0 |
| C₁₈H₃₇OH | 40 | | |
| C₂₀H₄₁NH₂ | 60 | 0 | 0 |
| C₇H₁₅COOH | 20 | | |
| C₈H₁₇NH₂ | 800 | 0 | 0 |
| C₁₀H₂₁NH₂ | 250 | 0 | 0 |
| C₁₄H₂₉NH₂ | 200 | 0 | 0 |
| C₁₈H₃₇NH₂ | 150 | 0 | 0 |
| C₂₀H₄₁NH₂ | 100 | 0 | 0 |
| (C₁₀H₂₁)₂NH | 100 | 0 | 0 |

### Example 7:

SiO₂ on a silicon wafer was etched with the use of a solution prepared by adding 800 ppm of C₁₄H₂₉NH₂ and 400 ppm of C₈H₁₇COOH to a colution containing 14% ammonium inspected by a microscope, no stain was found. Table 13 shows the result.

### Comparative Example 5:

SiO₂ on a silicon wafer was etched with the use of a solution prepared by adding 100 ppm of C₁₄H₂₉NH₂ and 60 ppm of C₈H₁₇COOH to a solution containing 14% ammonium fluoride and 2.4% fluoric acid, then the silicon wafer was inspected by a microscope, stain was found. Table 13 shows the result.

**TABLE 13**

| | Example 7 | Comparative example 5 |
|---|---|---|
| Etching composition | | |
| NH₄F | 14.0 % | 38.1 % |
| HF | 2.4 % | 2.4 % |
| C₁₄H₂₉NH₂ | 800 ppm | 100 ppm |
| C₈H₁₇COOH | 400 ppm | 60 ppm |
| Detected % of stain | 0 % | 5 to 10% |

In this respect, occurrence of stain in the men tioned Example 7 and Comparative Example 5 means that SiO was not etched evenly but remains in the form of stain. As is obvious from Comparative Example 5, it is understood from the table that addition of surfactant results in occurrence of stain if content of ammonium fluoride is high and therefore it is impossible to add a large amount of surfactant. of surfactant.

It is further understood from the table that even when surfactant is used together, no desired result is achieved if concentration of ammonium fluoride is high.

### Example 8:

As a result of cleaning a P-type silicon wafer processed by CZ method with the use of a solution containing 5% NH₄F, 1.7% HF, 80 ppm C₁₄H₂₇NH₂ and 40 ppm C₈H₁₇COOH and inspecting the cleaned wafer by microscope, the surface of the cleaned wafer was found smooth. Table 14 shows the result.

### Comparative Example 6:

As a result of cleaning a P-type silicon wafer processed by CZ method with the use of 4.9% HF solution having the same etching speed as Example 8, dry spot was found on the surface. Table 14 shows the result.

**TABLE 14**

| | Example 8 | | Comparative example 6 | |
|---|---|---|---|---|
| Composition of cleaning solution | NH₄F | 5.0 % | | |
| | HF | 1.7 % | HF | 4.9 % |
| | C₁₄H₂₇NH₂ | 80 ppm | | |
| | C₈H₁₇COOH | 40 ppm | | 2.4 % |
| Etching rate | 300 Å/min | | 300 Å/min | |
| Contct angle | 32 degrees | | 79 degrees | |
| Wafer surface | smooth | | found dry spot | |
| Illustration simulated SEM photo | Fig. 7A | | Fig. 7B | |

### Example 9:

Using the treatment agent according to the invention, a resist (OFPR-800) was applied to a silicon wafer to be 13000 Å in film thickness, then contact hole of 10 µm was provided for etching. As a result of microscope inspection, no abnormality was found on the resist. Figure 15 shows the result.

**TABLE 15**

| | | | |
|---|---|---|---|
| Composition | NH₄F | 10 % | 14.5 % |
| | HF | 4.0 % | 5.0 % |
| | C₁₂H₂₅NH₂ | 100 ppm | 150 ppm |
| | C₇H₁₅COOH | 80 ppm | 100 ppm |
| Etching rate | | 800 Å/min | 1000 Å/min |
| Abnormality | | not found | not found |

### Example 10:

A surfactant was added to an aqueous solution containing 10% NH₄F and 1% HF, and foaming thereby was tested.

In the measurement, 10 ml of treatment agent was put in a plastic receptacle of 30 mm in internal diameter and 70mm in height, then the receptacle was shaked for 10 seconds. Time spent from shaking to deforming was counted. Table 16 shows the result.

**TABLE 16**

| RUN | Surfactant | Amount added (ppm) | defoaming time (min) | Contact angle(°) |
|---|---|---|---|---|
| 1 | C₈H₁₇NH₂ | 1500 | longer than 3 | 35 |
| 2 | C₈H₁₇NH₂ | 1000 | shorter than 1 | 36 |
| | C₈H₁₇COOH | 300 | | |
| 3 | C₈H₁₇NH | 1000 | shorter than 1 | 35 |
| | C₈H₁₇OH | 300 | | |
| 4 | C₁₄H₂₉NH₂ | 200 | longer than 3 | 40 |
| 5 | C₁₄H₂₉NH₂ | 130 | shorter than 1 | 39 |
| | C₁₀H₂₁COOH | 40 | | |
| 6 | C₁₄H₂₉NH₂ | 130 | shorter than 1 | 39 |
| | C₁₀H₂₁OH | 40 | | |

## Claims

1. A surface treatment agent for fine surface treatment comprising an aqueous solution containing 0.01 to 8% by weight of hydrogen fluoride and 0.01 to 15% by weight (excluding 15% by weight) of ammonium fluoride, said aqueous solution further containing one surfactant selected from the group comprising aliphatic carboxylic acid, salt thereof, aliphatic amine, and aliphatic alcohol.

2. A surface treatment agent according to claim 1, said surfactant being an aliphatic amine, and said aqueous solution containing at least one additional surfactant selected from the group consisting of aliphatic carboxylic acid, salt thereof, and aliphatic alcohol.

3. A surface treatment agent according to claims 1 or 2, said surface treatment agent being an etching agent for silicon oxide film.

4. A surface treatment agent according to claims 1 or 2, said surface treatment agent being a cleaning agent for silicon surface and semiconductor device surface.

## Patentansprüche

1. Oberflächenbehandlungsmittel für feine Oberflächenbehandlung, das eine wäßrige Lösung beinhaltet, die 0.01 bis 8 Gew% Fluorwasserstoff und 0.01 bis 15 Gew% (ausgenommen 15 Gew%) Ammoniumfluorid enthält, wobei die genannte wäßrige Lösung außerdem einen oberflächenaktiven Stoff enthält, ausgewählt aus der Gruppe, die aliphatische Carbonsäure, deren Salz, aliphatisches Amin und aliphatischen Alkohol umfaßt.

2. Oberflächenbehandlungsmittel nach Anspruch 1, wobei der genannte oberflächenaktive Stoff ein aliphatisches Amin ist und die genannte wäßrige Lösung zumindest einen weiteren oberflächenaktiven Stoff enthält, ausgewählt aus der Gruppe bestehend aus aliphatischer Carbonsäure, deren Salz und aliphatischem Alkohol.

3. Oberflächenbehandlungsmittel nach Anspruch 1 oder 2, wobei das genannte Oberflächenbehandlungsmittel ein Ätzmittel für Siliziumoxidfilme ist.

4. Oberflächenbehandlungsmittel nach Anspruch 1 oder 2, wobei das genannte Oberflächenbehandlungsmittel ein Reinigungsmittel für Siliziumoberflächen und Oberflächen von Halbleiterbauelementen ist.

## Revendications

1. Un agent de traitement de surface pour traitement de surface fin, comprenant une solution aqueuse contenant 0,01 à 8 % en poids de fluorure d'hydrogène et 0,01 à 15 % en poids (à l'exclusion de 15 % en poids) de fluorure d'ammonium, ladite solution aqueuse contenant de plus un agent tensio-actif choisi dans le groupe formé par un acide carboxylique aliphatique, un sel de celui-ci, une amine aliphatique et un alcool aliphatique.

2. Un agent de traitement de surface selon la revendication 1, ledit agent tensio-actif étant une amine aliphatique, et ladite solution aqueuse contenant au moins un autre agent tensio-actif choisi dans le groupe formé par un acide carboxylique aliphatique, un sel de celui-ci et un alcool aliphatique.

3. Un agent de traitement de surface selon la revendication 1 ou 2, ledit agent de traitement de surface étant un agent de gravure pour couche d'oxyde de silicium.

4. Un agent de traitement de surface selon la revendication 1 ou 2, ledit agent de traitement de surface étant un agent de nettoyage pour surface de silicium et surface de dispositif à semi-conducteur.
